# EUROPEAN PATENT SPECIFICATION

(11) **EP 1 664 377 B1**
(45) Date of publication and mention of the grant of the patent: **16.11.2011**
(21) Application number: 04774873.6
(22) Date of filing: 12.08.2004
(51) Int. Cl.: C23C 16/513, C23C 16/52

(54) **METHOD AND AN APPARATUS FOR APPLYING A COATING ON A SUBSTRATE**
VERFAHREN UND VORRICHTUNG ZUM AUFBRINGEN EINES ÜBERZUGS AUF EIN SUBSTRAT
PROCEDE ET DISPOSITIF POUR L'APPLICATION DE REVETEMENT SUR UN SUBSTRAT

(30) Priority: 13.08.2003 NL 1024101
(43) Date of publication of application: 07.06.2006
(73) Proprietor: OTB Solar B.V., 5657 EB Eindhoven (NL)
(72) Inventor: BIJKER, Martin, Dinant, NL-5709 KR Helmond (NL); BOSCH, Roland, Cornelis, Maria, NL-5612 MC Eindhoven (NL); DINGS, Franciscus, Cornelius, 5505 TD Veldhoven (NL)
(74) Representative: Jansen, Cornelis Marinus
(86) International application number: PCT/NL2004/000566
(87) International publication number: WO 2005/017228

(56) References cited:
- EP-A- 0 985 742
- DE-A- 19 610 015
- US-A- 5 356 673
- US-A- 5 853 484
- US-A1- 2003 097 988
- US-B1- 6 293 222
- US-B1- 6 397 776

## Description

The invention relates to a method and an apparatus for applying a coating on a substrate.

More particularly, the invention relates to applying, by means of a number of expanding thermal plasma sources, a coating on a substrate having a considerable surface. The surface of the substrate is then so large that it cannot be covered by a single source. From the state of the art, various proposals are known to coat substrates having a large surface by means of ETP sources. In this connection, for instance, reference is made to EP-A-0 297 637, in which it is clearly indicated that multiple sources can be arranged in one process chamber. Further, reference is made to DE-196 10 015 A1, in which the use of multiple powder coating sources in a single process room for covering a moving substrate band is disclosed. US-6,397,776 B1 also describes an apparatus for depositing a coating on a large surface by means of multiple ETP sources. However, in none of these publications, is it indicated in what manner a uniform layer thickness of the coating over a relevant part of the substrate can be obtained. For instance, US-6,397,776 B1 ignores the fact that the plasma plumes of the ETP sources will interfere with each other and will push each other away. As a result of this phenomenon, interference-like deposition patterns have been found to arise between the sources, so that, there, the layer thickness is not uniform. The tables of tests included in the respective publication show considerable layer thickness differences.

As Fig. 1 of DE-196 10 015 A1 clearly shows, the distance between the aligned sources there is such that the coating tracks obtained in this manner do not touch each other. From this, it can be derived that the plasma plumes in this arrangement do not interfere with each other.

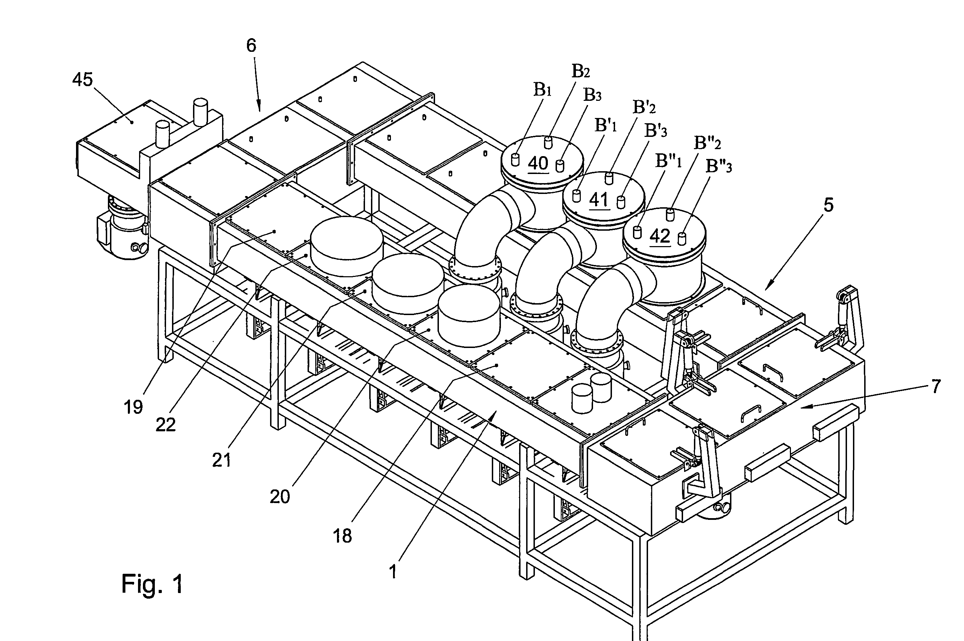

However, it is a problem to achieve that the parts of the passing substrate not yet covered with coating are completely and uniformly covered with a coating by a second row of sources. In the manner as shown Fig. 1, where some parts of the substrate are still completely uncovered after passing the first row of sources, it is impossible to obtain a uniform layer thickness.

Temperature differences over the surface of the substrate can also result in differences in layer thickness of the coating applied.

The invention contemplates a method and an apparatus by means of which such a uniform layer thickness can actually be obtained.

For this purpose, the invention provides a method for applying a coating on a substrate, in which, opposite the substrate, at least two expanding thermal plasma (ETP) sources are arranged which provide the substrate with a coating, the substrate being located in a process room in which the pressure is lower than the pressure, prevailing in the ETP sources, of a carrier gas which is introduced into the process room via the sources and which forms the expanding plasma, the coating applied by each source having a layer thickness according to a certain deposition profile, for instance a Gaussian deposition profile, and different process parameters being chosen such that, after the coating process, the addition of the deposition profiles results in a flat profile over the relevant part of the surface of the substrate and thus in a uniform layer thickness of the coating on a relevant part of the substrate, one of the process parameters to be chosen being the distance between sources producing plasma plumes at the same time, this distance being chosen or set such that the expanding plasmas substantially do not influence each other, in the sense that the shapes of the plasma plumes substantially correspond to the shape of a single plasma plume in a corresponding process chamber under otherwise corresponding process conditions.

The invention further provides an apparatus for carrying out the method according to the invention, which apparatus is provided with a process chamber enclosing a process room, pumping means for creating an underpressure in the process room, at least two expanding thermal plasma (ETP) sources through which a carrier gas is supplied to the process room under a higher pressure than the pressure prevailing in the process room, thereby forming an expanding plasma, and a substrate holder for carrying at least one substrate, the coating applied by each source having a layer thickness according to a certain deposition profile, for instance a Gaussian deposition profile, and different process parameters being settable such that, after the coating process, the addition of the deposition profiles results in a flat profile over the relevant part of the surface of the substrate and thus in a uniform layer thickness of the coating on a relevant part of the at least one substrate, one of the process parameters to be chosen being the distance between sources producing plasma plumes at the same time, this distance being chosen or set such that the expanding plasmas substantially do not influence each other, in the sense that the shapes of the plasma plumes substantially correspond to the shape of a single plasma plume in a corresponding process chamber under otherwise corresponding process conditions.

The deposition profile - for a source having a circular outflow opening, the deposition profile will generally be a circularly symmetric Gaussian deposition profile - provides the person who is to set the method with information regarding the layer thickness composition of a single source. Such deposition profiles depend on various process parameters such as for instance the pressure of the carrier gas in the source, the pressure prevailing in the process chamber, the arc flow prevailing in the source, the design of the source itself, the distance from the source to the substrate and similar quantities. For a single source, the various deposition profiles can be determined for different process parameters. When more than one source is used, a uniform layer thickness will be obtained when the addition of the different deposition profiles after the deposition process on the substrate has resulted in a flat profile over the relevant part of the surface of the substrate. As indicated hereinabove, temperature differences of the substrate itself can also result in differences in layer thickness of the coating. Other process conditions can also result in layer thickness differences which are difficult to predict theoretically. As a result of the fact that the distance of the ETP sources switched on at the same time is so great that the expanding plasmas do not influence each other, the above-described interference-like deposition patterns resulting from interaction between sources arranged too close to each other do not occur. The deposition profiles thus remain separated from each other so that the theoretical addition made for obtaining a uniform or flat deposition profile actually results in a uniform layer thickness in practice.

According to a further elaboration of the invention, these layer thickness differences which cannot well be predicted can be measured over the surface of the substrate of the layer obtained after the coating process, after which the process parameters are adjusted for reducing the thickness variations observed.

According to a further elaboration of the invention, the measurement of the layer thickness can take place in-line and automatically and the adjustment of the process parameters can also take place automatically. However, an off-line measurement by an operator and the manual adjustment of the process parameters by this operator also fall within the scope of the present invention.

The measurement can take place directly by means of a layer thickness gauge, off line or in-line (automatically).

Further, indirect measurements are possible, which have the additional advantage that the risk of damage of the layer is minimal. Indirect measurements can be optical measurements which can be based on transmission or reflection. For substantially transparent objects, such as window screens, the transmission of light through the object provides information about the layer thickness and about the uniformity or homogeneity of the layer over the surface. Further, information can be obtained about the optical characteristics of the layer which has been applied. For non-transparent objects, such as e.g. solar cells, the color of the cell provides information about the layer thickness. By scanning the surface of the solar cell with light having a particular wave length, the homogeneity of the color over the surface can be determined.

For layers which are capable of conducting electricity, a resistance measurement between two or more points on the surface can provide information about the uniformity or homogeneity of the layer thickness.

Because the substrate is, mostly, heated during the deposition process, a temperature measurement of the substrate can also provide information about the uniformity or homogeneity of the layer thickness.

According to a further elaboration of the invention, with a stationary substrate, the most neighboring sources can be switched on in alternation. Then, the sources can be actually arranged closely to each other, but the most neighboring sources are prevented from being switched on at the same time, so that it is thus achieved that the plasma plumes of the most neighboring sources cannot influence each other because they are never present at the same time. Of course, with such a batch production, first, coating will be formed in which peaks and holes are present. When, subsequently, the neighboring sources which were first switched off are switched on and the sources first switched on are switched off, the holes in the coating will gradually be filled and, thus, a substantially uniform layer thickness can be obtained without interference-like phenomena occurring therein.

According to an alternative further elaboration of the method according to the invention, the substrate is moved relative to the sources in a conveying direction, while all sources are switched on at the same time, the mutual distance between neighboring sources being chosen such that the expanding plasmas substantially do not influence each other, in the sense that the shapes of the plasma plumes substantially correspond to the shape of a single plasma plume in a corresponding process chamber, while, viewed in the conveying direction, at least one of the sources is arranged behind or in front of the other sources, the positions of the sources in a direction transverse to the conveying direction being such that the projection position of one of the three sources is located in the middle between the projection positions of the other two sources.

According to a further elaboration, a practical design in which a minimal use of space in a longitudinal direction is required is obtained using a method in which three sources are provided which are located on the angular points of an imaginary triangle, with two angular points being located on an imaginary line extending transversely across the conveying direction and with the third angular point being at equal distances from the two other angular points.

According to a further elaboration of the invention, the apparatus can be **characterized in that** the sources are mounted slidably relative to the process chamber in a direction transverse to the conveying direction. By means of such an apparatus, the uniform layer thickness can simply be obtained by taking a number of samples, allowing, when a variation occurs in the layer thickness viewed transversely to the conveying direction of the substrate, the distance between the sources to be increased or decreased. As already indicated hereinabove, the samples can also be taken in-line and automatically and the adjustment of the distance between the sources can also be taken automatically on the basis of the layer thickness measurements taken in-line.

Optionally, the apparatus can be **characterized in that** sources are tiltably mounted on the process chamber, such that the outflow angle of the various plasma plumes relative to the substrate can be varied.

According to a further elaboration, the apparatus is further provided with a control for varying, preferably independently of one another, the arc flow, the pressure of the carrier gas in the various ETP sources, and/or the pressure in the process chamber. The invention will be further elucidated on the basis of an exemplary embodiment of the apparatus with reference to the drawings, in which:
Fig. 1 shows a perspective view of an assembly for treating substrates;
Fig. 2 shows the deposition profiles of three sources arranged in a triangle configuration;
Fig. 3 shows a top plan view of three slidably arranged sources;
Fig. 4 shows a diagrammatic top plan view of three sources arranged in a triangle configuration;
Fig. 5 shows a diagrammatic top plan view of three sources arranged in a line configuration; and
Fig. 6 shows a diagrammatic top plan view of a number of sources which can be switched on in alternation.
Fig. 1 shows a perspective view of an assembly for treating substrates, which assembly is described in European patent application 03 076554.9 whose contents should considered inserted here.

The assembly shown is provided with a number of process chambers 40, 41, 42 and with a conveying system, extending in a conveying housing, provided with carriers mobile over rails by means of which a substrate which is to be subjected to a coating treatment can be moved along process chambers 40, 41, 42. As described in the European patent application mentioned, in the process chambers, a PECVD process can take place in which use is made of, for instance, expanding thermal plasma sources. In contrast to the European patent application mentioned, Fig. 1 of the present application shows that each process chamber is provided with three PECVD sources, more particularly ETP sources.

In order to obtain a good uniform layer thickness on the passing substrate, it is important that the different process parameters in a process chamber are chosen such that, after the coating process, the addition of the deposition profiles results in a substantially uniform layer thickness of the coating on a relevant part of the substrate. Here, one of the process parameters is the distance between the ETP sources producing plasma plumes at the same time, this distance being chosen and/or set such that the expanding plasmas substantially do not influence each other, in the sense that the shapes of the plasma plumes substantially correspond to the shape of a single plasma plume in a corresponding process chamber under otherwise corresponding process conditions.

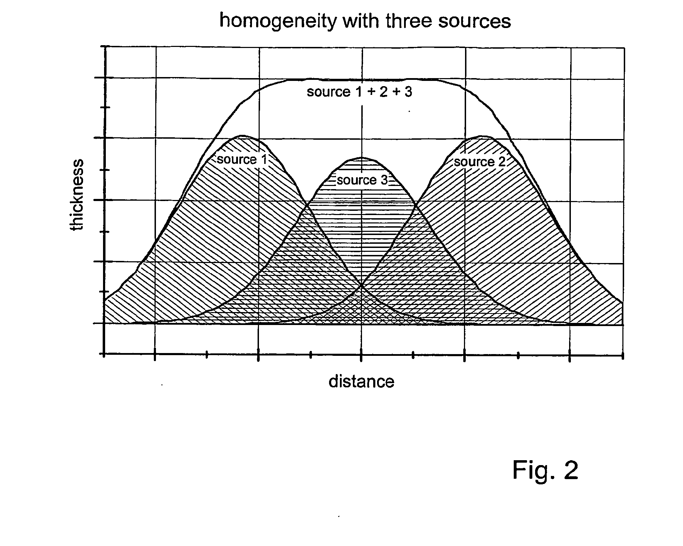

Fig. 2 shows the shape of a deposition profile of three sources. The sources have a circular plasma outflow opening, so that the resulting deposition profile on a passing substrate is a Gaussian profile. It is clearly visible that, with a proper positioning of the sources and with a right shape of the deposition profile, a resulting deposition profile can be obtained which results in a uniform layer thickness on a relevant part of the substrate. Here, the width of the deposition profile can, for instance, be influenced by the arc flow used in the respective source. Further, the shape of the deposition profile can be influenced by the pressure of the carrier gas in the source and the pressure prevailing in the process chamber. Preferably, the pressure of the carrier gas in the source is controllable per source, more specifically independently of each other. Although some overlap between the deposition profiles of sources B1 and B2 is present, this overlap is so slight that the plasma plumes of the sources B1 and B2 do not push each other away or influence each other in such a manner that interference-like patterns in the layer thickness composition occur. The slight overlap between the deposition profiles of sources B1 and B2 actually contributes to the uniformity of the resulting layer thickness, which appears from the addition of the deposition profiles.

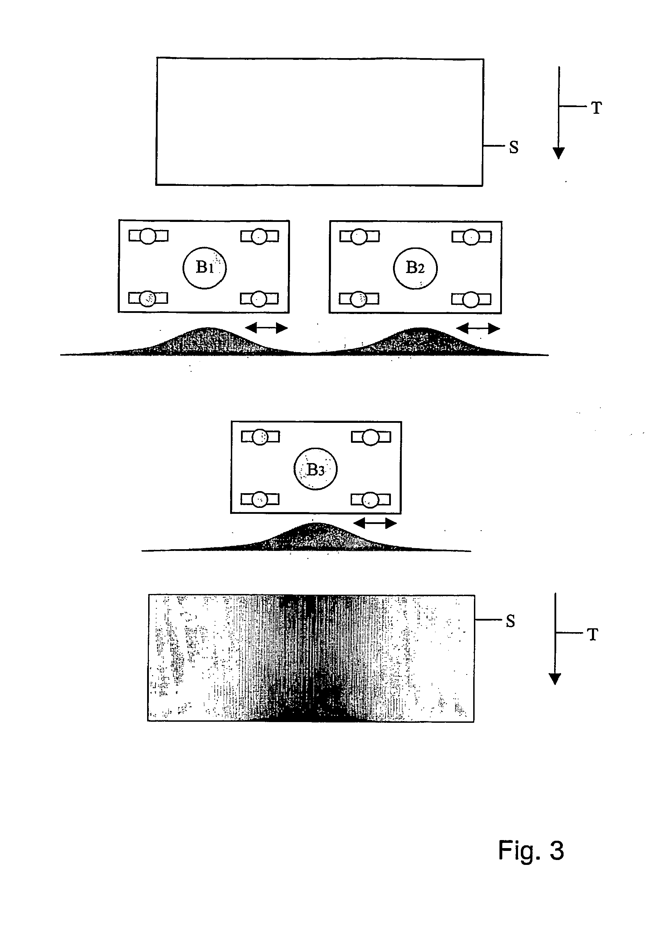

Fig. 3 shows a top plan view of the arrangement of three ETP sources, at least of the source plates on which these sources are mounted and a substrate located upstream of these sources and a substrate located downstream of these sources which is covered with a coating. Further, per source, the respective deposition profile is shown. It is clearly visible that the source plates are arranged slidably in a direction transverse to the conveying direction T, so that the distance between the various deposition profiles can be set in order to obtain a uniform layer thickness of the coating on the substrate. Optionally, the sources can also be tiltably arranged. As already indicated hereinabove, downstream of the sources, a measuring device can be arranged by means of which the layer thickness of the coating just applied can be measured. Depending on the measurement results, the positions of the sources and, optionally, other process parameters, can be adjusted automatically or manually. It will be clear that, in a variant in which the substrate does not move, the measuring device is arranged in the process chamber for observing the layer thickness on the different parts of the substrate.

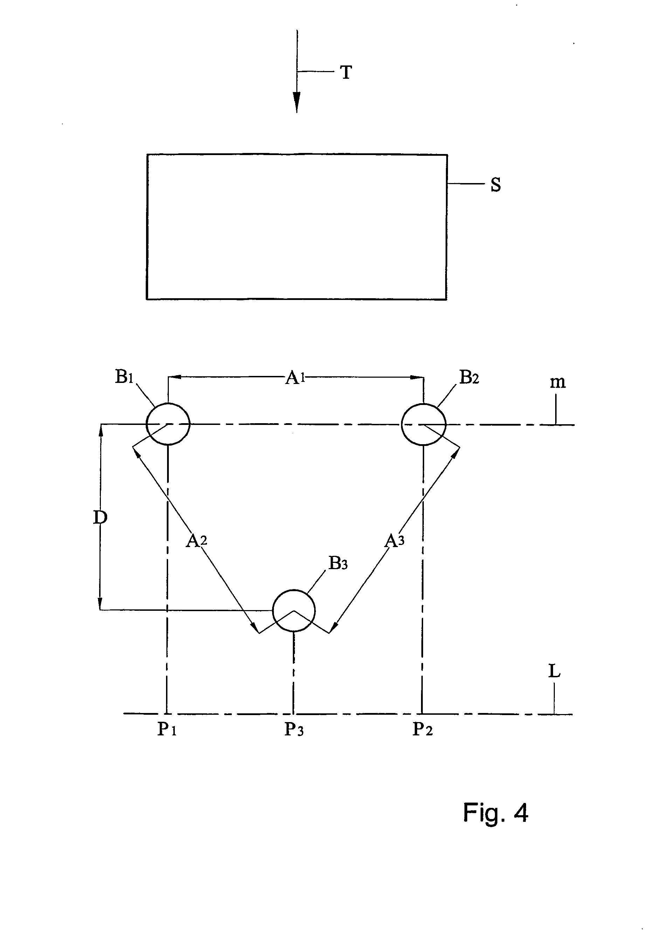

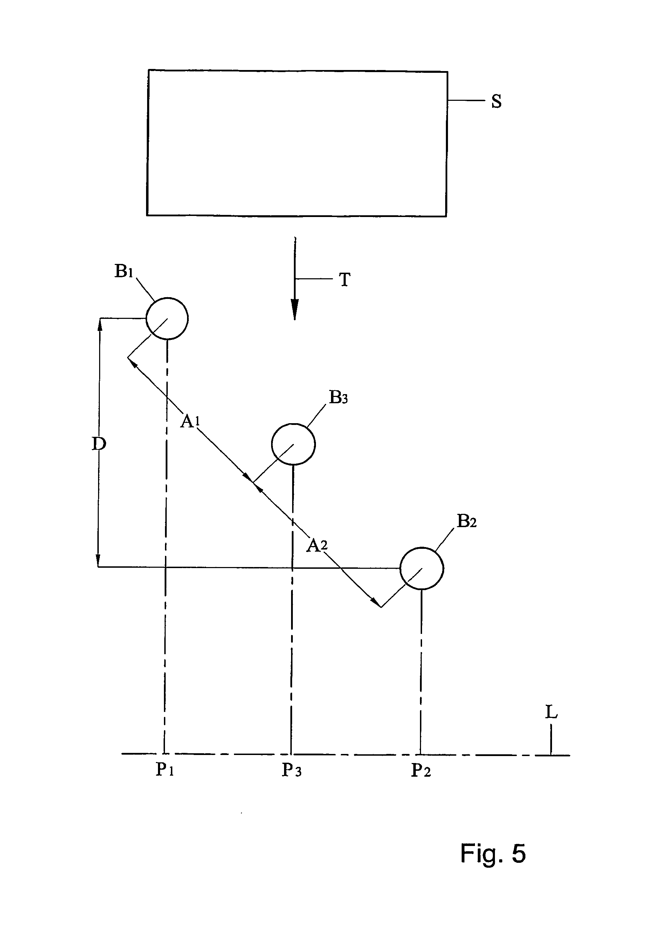

Figs. 4 and 5 further clarify the terminology of particularly claims 4 and 13. Both Figures show a set of three sources B1, B2, B3, and a substrate S moving in a conveying direction T below the sources B1-B3. In the exemplary embodiment of Fig. 4, the sources B1, B2, B3 are located on the angular points of an imaginary triangle. Two angular points are located on an imaginary line M extending transversely to the conveying direction T. The third angular point, on which source B3 is located, is at equal distances A2, A3 from the two other angular points. It holds true for both Fig. 4 and Fig. 5 that one of the two sources - in Fig. 4 source B3 and in Fig. 5 source B2 - is arranged behind the other sources. The positions of the sources B1, B2, B3 in a direction transverse to the conveying direction are such that the neighboring projections P1, P2, P3 of the three sources on an imaginary line L extending transversely to the conveying direction T are such that the projection position of one of the three sources P3 is located in the middle between the projection positions P1, P2 of the other two sources. The advantage of the exemplary embodiment of Fig. 4 compared to that of Fig. 5 is that the required conveying length D to apply the respective coating is minimal.

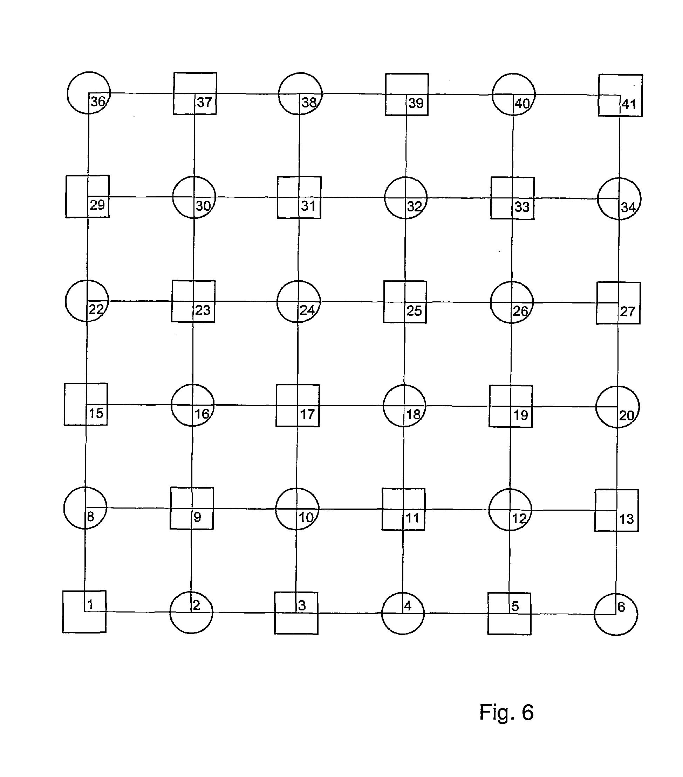

Fig. 6 shows an exemplary embodiment of an arrangement of a number of sources 1-41, which sources are located on the angular points of an imaginary grid. The respective arrangement is particularly intended for coating a stationary substrate located opposite the sources. If all sources were switched on at the same time, their plasma plumes would influence each other, which results in interference-like patterns in the layer thickness of the coating. By first switching on the sources designated by even numbers and then switching them off, after which the sources with the odd numbers are switched on, it is achieved that, first, a coating is formed having peaks and holes, with the holes being gradually filled in the second deposition step, so that the final result is a coating with a substantially uniform layer thickness. In other words, the neighboring sources are switched on in alternation, with this terminology also comprising the variant that only two steps are passed through, viz., first, switching on the odd sources (designated by squares for reasons of clarity) and, in a second step, switching on the even sources (designated by circles for reasons of clarity), in which second step, the odd sources are switched off.

It will be clear that the invention is not limited to the exemplary embodiments described but that various modifications are possible within the scope of the invention.

## Claims

1. A method for applying a coating on a substrate, wherein, opposite the substrate, at least two expanding thermal plasma (ETP) sources are arranged which provide the substrate with a coating, wherein the substrate is located in a process room in which the pressure is lower than the pressure, prevailing in the ETP sources, of a carrier gas which is introduced into the process room via the sources and which forms the expanding plasma, wherein the coating provided by each source has a layer thickness according to a certain deposition profile, for instance a Gaussian deposition profile, and wherein different process parameters are chosen such that, after the coating process, the addition of the deposition profiles results in a flat profile over the relevant part of the surface of the substrate and thus in a uniform layer thickness of the coating on a relevant part of the substrate, one of the process parameters to be chosen being the distance between sources producing plasma plumes at the same time, this distance being chosen or set such that the expanding plasmas substantially do not influence each other, in the sense that the shapes of the plasma plumes substantially correspond to the shape of a single plasma plume in a corresponding process chamber under otherwise corresponding process conditions.

2. A method according to claim 1, wherein thickness variations are measured over the surface of the substrate of the layer obtained after the coating process, wherein, subsequently, the process parameters are adjusted for reducing the thickness variations observed.

3. A method according to claim 1 or 2, wherein the substrate is stationary relative to the sources and wherein the most neighboring sources are switched on in alternation.

4. A method according to claim 1 or 2, wherein the substrate is moved relative to the sources in a conveying direction, wherein all sources are switched on at the same time and wherein the mutual distance between neighboring sources is chosen such that the expanding plasmas substantially do not influence each other, in the sense that the shapes of the plasma plumes substantially correspond to the shape of a single plasma plume in a corresponding process chamber, wherein at least one of the sources, viewed in the conveying direction, is arranged behind or in front of the other sources and wherein the positions of the sources in a direction transverse to the conveying direction are such that the neighboring projections of three sources on an imaginary line extending transverse to the conveying direction are such that the projection position of one of the three sources is located in the middle between the other two sources.

5. A method according to claim 4, wherein three sources are provided which are located on the angular points of an imaginary triangle, wherein two angular points are located on an imaginary line extending transversely to the conveying direction and wherein the third angular point is at equal distances from the other two angular points.

6. A method according to any one of the preceding claims, wherein one of the process parameters to be chosen, and to be varied depending on the other process parameters, for influencing the resulting layer thickness uniformity is the arc flow of the various ETP sources.

7. A method according to claims 5 and 6, wherein the arc flow of the source located on the third angular point is chosen to be lower than the arc flows of the other two sources.

8. A method according to any one of the preceding claims, wherein one of the process parameters to be chosen, and to be varied depending on the other process parameters, for influencing the resulting layer thickness uniformity is the pressure of the carrier gas in the source.

9. A method according to any one of the preceding claims, wherein one of the process parameters to be chosen, and to be varied depending on the other process parameters, for influencing the resulting layer thickness uniformity is the mutual positioning of the sources.

10. A method according to any one of the preceding claims, wherein one of the process parameters to be chosen, and to be varied depending on the other process parameters, for influencing the resulting layer thickness uniformity is the outflow angle of the plasma plumes relative to the substrate.

11. A method according to claim 2, wherein the measurement of the layer thickness is performed automatically.

12. A method according to claim 2, wherein the measurement of the layer thickness is performed by means of an optical measurement.

13. A method according to claim 2, wherein the measurement of the layer thickness is performed by means of an resistance measurement between two or more points on the layer.

14. A method according to claim 2, wherein the measurement of the layer thickness is performed by means of a layer thickness gauge.

15. A method according to claim 2, wherein the measurement of the layer thickness is performed by means of a temperature measurement of the substrate surface.

16. An apparatus for carrying out the method according to any one of the preceding claims for forming a coating on a substrate, which apparatus is provided with a process chamber enclosing a process room, pumping means for creating an underpressure in the process room, at least two expanding thermal plasma (ETP) sources through which a carrier gas is supplied to the process room, under a higher pressure than the pressure prevailing in the process room, thereby forming an expanding plasma, and a substrate holder for carrying at least one substrate, wherein the coating applied by each source has a layer thickness according to a certain deposition profile, for instance a Gaussian deposition profile, and wherein different process parameters are settable such that, after the coating process, the addition of the deposition profiles results in a flat profile over the relevant part of the surface of the substrate and thus in a uniform layer thickness of the coating on a relevant part of the at least one substrate, one of the process parameters to be chosen being the distance between sources producing plasma plumes at the same time, this distance being chosen or set such that the expanding plasmas substantially do not influence each other, in the sense that the shapes of the plasma plumes substantially correspond to the shape of a single plasma plume in a corresponding process chamber under otherwise corresponding process conditions.

17. An apparatus according to claim 16, wherein the apparatus is provided with a measuring device for measuring the layer thickness variations over the surface of the substrate, wherein the apparatus is provided with a control for automatically setting at least a number of the process parameters to be set depending on the layer thickness variations measured by the measuring device.

18. An apparatus according to claim 16 or 17, wherein the substrate is stationary relative to the sources and wherein the most neighboring sources can be switched on in alternation.

19. An apparatus according to claim 16 or 17, wherein the substrate is arranged movably relative to the sources in a conveying direction, wherein all sources are switched on at the same time and wherein the mutual distance between neighboring sources is chosen such that the expanding plasmas substantially do not influence each other, in the sense that the shapes of the plasma plumes substantially correspond to the shape of a single plasma plume in a corresponding process chamber, wherein at least one of the sources, viewed in the conveying direction, is arranged behind or in front of the other sources and wherein the positions of the sources in a direction transverse to the conveying direction are such that the neighboring projections of three sources on an imaginary line extending transverse to the conveying direction are such that the projection position of one of the three sources is located in the middle between the other two sources.

20. An apparatus according to claim 19, wherein three sources are provided which are located on the angular points of an imaginary triangle, wherein two angular points are located on an imaginary line extending transversely to the conveying direction and wherein the third angular point is at equal distances from the other two angular points.

21. An apparatus according to claim 20, wherein the sources are slidable relative to the process chamber.

22. An apparatus according to claim 21, wherein, for the variant wherein the substrate moves in a conveying direction (T) relative to the sources, the sources are slidable in a direction transverse to the conveying direction.

23. An apparatus according to any one of claims 16-22, wherein the sources are tiltably mounted on the process chamber, such that the angle of the plasma plumes relative to the substrate is variable.

24. An apparatus according to any one of claims 16-23, provided with a control arranged for varying, preferably independently of one another, the arc flows of the various ETP sources.

25. An apparatus according to any one of claims 16-24, provided with a control arranged for varying, preferably independently of one another, the pressure of the carrier gas in the various ETP sources.

26. An apparatus according to claim 17, wherein the measurement of the layer thickness is performed automatically.

27. An apparatus according to claim 17, wherein the measuring device for measuring the layer thickness variations over the surface of the substrate comprises an optical measurement device.

28. An apparatus according to claim 17, the measuring device for measuring the layer thickness variations over the surface of the substrate comprises an resistance measurement device for resistance measurement between two or more points on the layer.

29. An apparatus according to claim 17, the measuring device for measuring the layer thickness variations over the surface of the substrate comprises a layer thickness gauge.

30. An apparatus according to claim 17, the measuring device for measuring the layer thickness variations over the surface of the substrate comprises an temperature measurement device for temperature measurement of the substrate surface.

## Patentansprüche

1. Verfahren zum Aufbringen einer Beschichtung auf ein Substrat, wobei gegenüber dem Substrat zumindest zwei Quellen eines sich thermisch ausdehnenden Plasmas (ETP) angeordnet sind, die das Substrat mit einer Beschichtung versehen, wobei das Substrat in einem Bearbeitungsraum angeordnet ist, in dem der Druck niedriger als der in den ETP-Quellen herrschende Druck eines Trägergases ist, das in den Bearbeitungsraum mittels der Quellen eingeführt wird und welches das sich ausdehnende Plasma bildet, wobei die Beschichtung, die durch jede Quelle vorgesehen wird, eine Schichtdicke gemäß einem bestimmten Ablagerungsprofil, zum Beispiel einem Gaußschen Ablagerungsprofil, aufweist und wobei verschiedene Bearbeitungsparameter so gewählt sind, dass nach der Beschichtungsbearbeitung das Hinzufügen der Ablagerungsprofile zu einem flachen Profil des relevanten Teils der Oberfläche des Substrats und so zu einer gleichförmigen Schichtdicke der Beschichtung an einem relevanten Teil des Substrats führt, wobei einer der Bearbeitungsparameter so zu wählen ist, dass der Abstand zwischen Quellen, die Plasmafahnen zur selben Zeit erzeugen, so gewählt oder bestimmt ist, dass sich die sich ausdehnenden Plasmen im Wesentlichen nicht gegenseitig beeinflussen, in der Hinsicht, dass die Formen der Plasmafahnen im Wesentlichen der Form einer einzelnen Plasmafahne in einer entsprechenden Bearbeitungskammer unter ansonsten entsprechenden Bearbeitungsbedingungen entsprechen.

2. Verfahren nach Anspruch 1, bei dem Dickenabweichungen der Oberfläche des Substrats der Schicht, die nach der Beschichtungsbearbeitung erhalten wird, gemessen werden, wobei anschließend die Bearbeitungsparameter zum Reduzieren der beobachteten Dickenabweichungen eingestellt werden.

3. Verfahren nach Anspruch 1 oder 2, bei dem das Substrat stationär bezüglich der Quellen ist und bei dem die nächsten benachbarten Quellen abwechselnd angesprochen werden.

4. Verfahren nach Anspruch 1 oder 2, bei dem das Substrat bezüglich der Quellen in eine Transportrichtung bewegt wird, wobei alle Quellen zur selben Zeit angesprochen werden und wobei der gegenseitige Abstand zwischen benachbarten Quellen so gewählt ist, dass sich die sich ausdehnenden Plasmen im Wesentlichen nicht gegenseitig beeinflussen, in der Hinsicht, dass die Formen der Plasmafahnen im Wesentlichen der Form einer einzelnen Plasmafahne in einer entsprechenden Bearbeitungskammer entsprechen, wobei zumindest eine der Quellen, in der Transportrichtung betrachtet, hinter oder vor den anderen Quellen angeordnet ist und wobei die Positionen der Quellen in einer Richtung quer zu der Transportrichtung so sind, dass die benachbarten Projektionen der drei Quellen auf einer imaginären Linie, die sich quer zu der Transportrichtung erstreckt, so sind, dass die Projektionsposition eine der drei Quellen in der Mitte zwischen den anderen zwei Quellen angeordnet ist.

5. Verfahren nach Anspruch 4, bei dem drei Quellen vorgesehen sind, die an den Eckpunkten eines imaginären Dreiecks angeordnet sind, wobei zwei Eckpunkte auf einer imaginären Linie angeordnet sind, die sich quer zu der Transportrichtung erstreckt, und wobei der dritte Eckpunkt in gleichen Abständen zu den anderen zwei Eckpunkten liegt.

6. Verfahren nach einem der vorhergehenden Ansprüche, bei dem einer der Bearbeitungsparameter, die zu wählen und in Abhängigkeit von den anderen Bearbeitungsparametern zum Beeinflussen der resultierenden Schichtdickengleichförmigkeit zu ändern sind, der Kantenfluss der verschiedenen ETP-Quellen ist.

7. Verfahren nach Ansprüchen 5 und 6, bei dem der Kantenfluss der Quelle, die an dem dritten Eckpunkt angeordnet ist, so gewählt ist, dass er kleiner als die Kantenflüsse der anderen zwei Quellen ist.

8. Verfahren nach einem der vorhergehenden Ansprüche, bei dem einer der Bearbeitungsparameter, die zu wählen und in Abhängigkeit von den anderen Bearbeitungsparametern zum Beeinflussen der resultierenden Schichtdickengleichförmigkeit zu ändern sind, der Druck des Trägergases in der Quelle ist.

9. Verfahren nach einem der vorhergehenden Ansprüche, bei dem einer der Bearbeitungsparameter, die zu wählen und in Abhängigkeit von den anderen Bearbeitungsparametern zum Beeinflussen der resultierenden Schichtdickengleichförmigkeit zu ändern sind, das gegenseitige Positionieren der Quellen ist.

10. Verfahren nach einem der vorhergehenden Ansprüche, bei dem einer der Bearbeitungsparameter, die zu wählen und in Abhängigkeit von den anderen Bearbeitungsparametern zum Beeinflussen der resultierenden Schichtdickengleichförmigkeit zu ändern sind, der Ausfluss-Winkel der Plasmafahnen bezüglich des Substrats ist.

11. Verfahren nach Anspruch 2, bei dem die Messung der Schichtdicke automatisch durchgeführt wird.

12. Verfahren nach Anspruch 2, bei dem die Messung der Schichtdicke mittels einer optischen Messung durchgeführt wird.

13. Verfahren nach Anspruch 2, bei dem die Messung der Schichtdicke mittels einer Widerstandsmessung zwischen zwei oder mehr Punkten an der Schicht durchgeführt wird.

14. Verfahren nach Anspruch 2, bei dem die Messung der Schichtdicke mittels einer Schichtdickeneichung durchgeführt wird.

15. Verfahren nach Anspruch 2, bei dem die Messung der Schichtdicke mittels einer Temperaturmessung der Substratoberfläche durchgeführt wird.

16. Vorrichtung zum Durchführen des Verfahrens nach einem der vorhergehenden Ansprüche zum Ausbilden einer Beschichtung auf ein Substrat, wobei die Vorrichtung mit einer Bearbeitungskammer, die einen Bearbeitungsraum umschließt, Pumpmitteln zum Erzeugen eines Unterdrucks in dem Bearbeitungsraum, zumindest zwei Quellen eines sich thermisch ausdehnenden Plasmas. (ETP), durch die ein Trägergas in den Bearbeitungsraum eingegeben wird, und zwar unter einem höheren Druck als der in dem Bearbeitungsraum herrschende Druck, wodurch ein sich ausdehnendes Plasma gebildet wird, und einem Substrathalter zum Tragen zumindest eines Substrats vorgesehen ist, wobei die Beschichtung, die durch jede Quelle aufgebracht wird, eine Schichtdicke gemäß einem bestimmten Ablagerungsprofil, zum Beispiel einem Gaußschen Ablagerungsprofil, aufweist und wobei verschiedene Bearbeitungsparameter bestimmbar sind, sodass nach der Beschichtungsbearbeitung das Hinzufügen von
Ablagerungsprofilen zu einem flachen Profil des relevanten Teils der Oberfläche des Substrats und so zu einer gleichförmigen Schichtdicke der Beschichtung an einem relevanten Teil des zumindest einen Substrats führt, wobei einer der zu wählenden Bearbeitungsparameter der Abstand zwischen Quellen ist, die Plasmafahnen zur selben Zeit erzeugen, wobei dieser Abstand so gewählt oder bestimmt ist,
dass sich die sich ausdehnenden Plasmen im Wesentlichen nicht gegenseitig beeinflussen, in der Hinsicht, dass die Formen der Plasmafahnen im Wesentlichen der Form einer einzelnen Plasmafahne in einer entsprechenden Bearbeitungskammer unter ansonsten entsprechenden Bearbeitungsbedingungen entsprechen.

17. Vorrichtung nach Anspruch 16, bei der die Vorrichtung mit einem Messgerät zum Messen der Schichtdickenabweichungen der Oberfläche des Substrats versehen ist, wobei die Vorrichtung mit einer Regelung zum automatischen Bestimmen zumindest einer Anzahl der Bearbeitungsparameter versehen ist, die in Abhängigkeit von der Schichtdickenabweichungen zu bestimmen sind, die mit dem Messgerät gemessen werden.

18. Vorrichtung nach Anspruch 16 oder 17, bei der das Substrat stationär bezüglich der Quellen ist und bei der die nächsten benachbarten Quellen abwechselnd angesprochen werden können.

19. Verfahren nach Anspruch 16 oder 17, bei dem das Substrat bezüglich der Quellen in eine Transportrichtung bewegt wird, wobei alle Quellen zur selben Zeit angesprochen werden und wobei der gegenseitige Abstand zwischen benachbarten Quellen so gewählt ist, dass sich die sich ausdehnenden Plasmen im Wesentlichen nicht gegenseitig beeinflussen, in der Hinsicht, dass die Formen der Plasmafahnen im Wesentlichen der Form einer einzelnen Plasmafahne in einer entsprechenden Bearbeitungskammer entsprechen, wobei zumindest eine der Quellen, in der Transportrichtung betrachtet, hinter oder vor den anderen Quellen angeordnet ist und wobei die Positionen der Quellen in einer Richtung quer zu der Transportrichtung so sind, dass die benachbarten Projektionen der drei Quellen auf einer imaginären Linie, die sich quer zu der Transportrichtung erstreckt, so sind, dass die Projektionsposition eine der drei Quellen in der Mitte zwischen den anderen zwei Quellen angeordnet ist.

20. Verfahren nach Anspruch 19, bei dem drei Quellen vorgesehen sind, die an den Eckpunkten eines imaginären Dreiecks angeordnet sind, wobei zwei Eckpunkte auf einer imaginären Linie angeordnet sind, die sich quer zu der Transportrichtung erstreckt, und wobei der dritte Eckpunkt in gleichen Abständen zu den anderen zwei Eckpunkten liegt.

21. Vorrichtung nach Anspruch 20, bei der die Quellen bezüglich der Bearbeitungskammer gleitbar sind.

22. Vorrichtung nach Anspruch 21, bei der für den Fall, dass sich das Substrat in eine Transportrichtung (T) bezüglich der Quellen bewegt, die Quellen in einer Richtung quer zu der Transportrichtung gleitbar sind.

23. Vorrichtung nach einem der Ansprüche 16 bis 22, bei der die Quellen neigbar an der Bearbeitungskammer angebracht sind, sodass der Winkel der Plasmafahnen bezüglich des Substrats variabel ist.

24. Vorrichtung nach einem der Ansprüche 16 bis 23, die mit einer Regelung versehen ist, die zum Ändern, vorzugweise unabhängig voneinander, der Kantenflüsse der verschiedenen ETP-Quellen angeordnet ist.

25. Vorrichtung nach einem der Ansprüche 16 bis 24, die mit einer Regelung versehen ist, die zum Ändern, vorzugsweise unabhängig voneinander, des Drucks des Trägergases in den verschiedenen ETP-Quellen vorgesehen ist.

26. Vorrichtung nach Anspruch 17, bei der die Messung der Schichtdicke automatisch durchgeführt wird.

27. Vorrichtung nach Anspruch 17, bei der das Messgerät zum Messen der Schichtdickenabweichungen der Oberfläche des Substrats ein optisches Messgerät aufweist.

28. Vorrichtung nach Anspruch 17, bei der das Messgerät zum Messen der Schichtdickenabweichungen der Oberfläche des Substrats ein Widerstandsmessgerät zur Widerstandsmessung zwischen zwei oder mehr Punkten der Schicht aufweist.

29. Vorrichtung nach Anspruch 17, bei der das Messgerät zum Messen der Schichtdickenabweichungen der Oberfläche des Substrats eine Schichtdickeneichung aufweist.

30. Vorrichtung nach Anspruch 17, bei der das Messgerät zum Messen der Schichtdickenabweichungen der Oberfläche des Substrats ein Temperaturmessgerät zum Temperaturmessen der Substratoberfläche aufweist.

## Revendications

1. Procédé d'application d'un revêtement sur un substrat, dans lequel sont agencées, en regard du substrat, au moins deux sources de plasma thermique en expansion (ETP) qui dotent le substrat d'un revêtement, dans lequel le substrat est situé dans une enceinte de process où règne une pression inférieure à la pression, à l'intérieur des sources ETP, d'un gaz porteur introduit dans l'enceinte de process via les sources et formant le plasma en expansion, dans lequel le revêtement fourni par chaque source présente une épaisseur de couche selon un certain profil de dépôt, par exemple un profil de dépôt gaussien, et dans lequel différents paramètres de process sont choisis de manière à ce que, après le processus de revêtement, l'addition des profils de dépôt donne un profil plat sur la partie concernée de la surface du substrat et, de ce fait, une épaisseur de couche uniforme du revêtement sur une partie concernée du substrat, un des paramètres du processus à choisir étant la distance entre les sources produisant simultanément des plumes de plasma, cette distance étant choisie ou réglée de manière à ce que les plasmas en expansion n'influent sensiblement pas les uns sur les autres, au sens où la forme des plumes de plasma correspond sensiblement à la forme d'une plume de plasma seule dans une chambre de process correspondante dans des conditions de process par ailleurs correspondantes.

2. Procédé selon la revendication 1, **caractérisé en ce que** l'on mesure les variations d'épaisseur de la couche obtenue après le processus de revêtement sur la surface du substrat, dans lequel les paramètres de process sont ajustés postérieurement en vue de réduire les variations d'épaisseur observées.

3. Procédé selon la revendication 1 ou la revendication 2, dans lequel le substrat est fixe par rapport aux sources et les sources les plus voisines sont mises sous tension en alternance.

4. Procédé selon la revendication 1 ou la revendication 2, dans lequel le substrat est entraîné dans une direction de déplacement par rapport aux sources, dans lequel toutes les sources sont mises sous tension simultanément et dans lequel la distance relative entre des sources voisines est choisie de manière à ce que les plasmas en expansion n'influent sensiblement pas les uns sur les autres, au sens où la forme des plumes de plasma correspond sensiblement à la forme d'une plume de plasma seule dans une chambre de process correspondante, dans lequel au moins une des sources, vue dans le sens du déplacement, est disposée derrière ou devant les autres sources et dans lequel les positions des sources, dans une direction transversale à la direction de déplacement, sont telles que les projections voisines de trois sources sur une ligne imaginaire s'étendant transversalement à la direction de déplacement sont telles que le point de projection de l'une des trois sources est situé au milieu entre les deux autres sources.

5. Procédé selon la revendication 4, dans lequel il est prévu trois sources situées aux sommets d'un triangle imaginaire, dans lequel deux sommets sont situés sur une ligne imaginaire qui s'étend transversalement à la direction de déplacement et dans lequel le troisième sommet est situé à équidistance des deux autres sommets.

6. Procédé selon l'une quelconque des revendications précédentes, dans lequel un des paramètres de process à choisir et à modifier en fonction des autres paramètres de process pour influer sur l'uniformité de l'épaisseur de la couche obtenue est le courant d'arc des différentes sources ETP.

7. Procédé selon les revendications 5 et 6, dans lequel le courant d'arc de la source située au niveau du troisième sommet est choisi inférieur aux courants d'arc des deux autres sources.

8. Procédé selon l'une quelconque des revendications précédentes, dans lequel un des paramètres de process à choisir et à modifier en fonction des autres paramètres de process pour influer sur l'uniformité de l'épaisseur de la couche obtenue est la pression du gaz porteur dans la source.

9. Procédé selon l'une quelconque des revendications précédentes, dans lequel un des paramètres de process à choisir et à modifier en fonction des autres paramètres de process pour influer sur l'uniformité de l'épaisseur de la couche obtenue est le positionnement relatif des sources.

10. Procédé selon l'une quelconque des revendications précédentes, dans lequel un des paramètres de process à choisir et à modifier en fonction des autres paramètres de process pour influer sur l'uniformité de l'épaisseur de la couche obtenue est l'angle de sortie des plumes de plasma par rapport au substrat.

11. Procédé selon la revendication 2, dans lequel le mesurage de l'épaisseur de couche s'effectue automatiquement.

12. Procédé selon la revendication 2, dans lequel l'épaisseur de couche est mesurée selon un procédé optique.

13. Procédé selon la revendication 2, dans lequel l'épaisseur de couche est mesurée par mesurage de la résistance entre deux points ou plus de la couche.

14. Procédé selon la revendication 2, dans lequel l'épaisseur de la couche est mesurée au moyen d'une jauge d'épaisseur de couche.

15. Procédé selon la revendication 2, dans lequel l'épaisseur de la couche est mesurée par mesurage de la température de la surface du substrat.

16. Dispositif permettant de mettre en oeuvre le procédé selon l'une quelconque des revendications précédentes pour former un revêtement sur un substrat, ledit appareil étant doté d'une chambre de process comprenant une enceinte de process, des moyens de pompage pour créer une dépression dans l'enceinte de process, au moins deux sources de plasma thermique en expansion (ETP) alimentant l'enceinte de process en gaz porteur sous une pression supérieure à la pression régnant dans l'enceinte de process, formant ainsi un plasma en expansion, et un support de substrat pour supporter au moins un substrat, dans lequel le revêtement appliqué par chaque source présente une épaisseur de couche selon un certain profil de dépôt, par exemple un profil de dépôt gaussien, et dans lequel différents paramètres de process sont réglables de manière à ce que, après le processus de revêtement, l'addition des profils de dépôt donne un profil plat sur la partie concernée de la surface du substrat et, de ce fait, une épaisseur de couche uniforme du revêtement sur une partie concernée du ou des substrats, un des paramètres du processus à déterminer étant la distance entre les sources produisant des plumes de plasma simultanément, cette distance étant choisie ou réglée de manière à ce que les plasmas en expansion n'influent sensiblement pas les uns sur les autres, au sens où la forme des plumes de plasma correspond sensiblement à la forme d'une plume de plasma seule dans une chambre de process correspondante dans des conditions de process par ailleurs correspondantes.

17. Dispositif selon la revendication 16, dans lequel le dispositif est doté d'un dispositif de mesure pour mesurer les variations d'épaisseur de la couche à la surface du substrat, dans lequel l'appareil est doté d'un système de commande pour régler automatiquement au moins un nombre de paramètres de processus à régler en fonction des variations d'épaisseur de couche mesurées par le dispositif de mesure.

18. Dispositif selon la revendication 16 ou la revendication 17, dans lequel le substrat est fixe par rapport aux sources et dans lequel les sources les plus voisines peuvent être mises sous tension en alternance.

19. Dispositif selon la revendication 16 ou la revendication 17, dans lequel le substrat est agencé mobile dans une direction de déplacement par rapport aux sources, dans lequel toutes les sources sont mises sous tension simultanément et dans lequel la distance relative entre des sources voisines est choisie de manière à ce que les plasmas en expansion n'influent sensiblement pas les uns sur les autres, au sens où la forme des plumes de plasma correspond sensiblement à la forme d'une plume de plasma seule dans une chambre de process correspondante, dans lequel au moins une des sources, vue dans le sens du déplacement, est disposée derrière ou devant les autres sources et dans lequel les positions des sources, dans une direction transversale à la direction de déplacement, sont telles que les projections voisines de trois sources sur une ligne imaginaire s'étendant transversalement à la direction de déplacement sont telles que le point de projection de l'une des trois sources est situé au milieu entre les deux autres sources.

20. Dispositif selon la revendication 19, dans lequel il est prévu trois sources situées aux sommets d'un triangle imaginaire, dans lequel deux sommets sont situés sur une ligne imaginaire qui s'étend transversalement à la direction de déplacement et dans lequel le troisième sommet est situé à équidistance des deux autres sommets.

21. Dispositif selon la revendication 20, dans lequel les sources peuvent coulisser par rapport à la chambre de process.

22. Dispositif selon la revendication 21, dans lequel dans la variante où le substrat se déplace dans une direction de déplacement (T) par rapport aux sources, les sources peuvent coulisser dans une direction transversale à la direction de déplacement.

23. Dispositif selon l'une quelconque des revendications 16 à 22, dans lequel les sources sont montées pivotantes sur la chambre de process, de manière à ce que l'angle des plumes de plasma par rapport au substrat soit variable.

24. Dispositif selon l'une quelconque des revendications 16 à 23, doté d'un dispositif de commande agencé pour faire varier, de préférence indépendamment les uns des autres, les courants d'arc des différentes sources ETP.

25. Dispositif selon l'une quelconque des revendications 16 à 24, doté d'un dispositif de commande agencé pour faire varier, de préférence indépendamment les uns des autres, la pression du gaz porteur dans les différentes sources ETP.

26. Dispositif selon la revendication 17, dans lequel le mesurage de l'épaisseur de la couche s'effectue automatiquement.

27. Dispositif selon la revendication 17, dans lequel le dispositif de mesure pour mesurer les variations d'épaisseur de la couche à la surface du substrat comprend un dispositif de mesure optique.

28. Dispositif selon la revendication 17, dans lequel le dispositif de mesure pour mesurer les variations d'épaisseur de couche à la surface du substrat comprend un dispositif de mesure de la résistance pour mesurer la résistance entre au moins deux points de la couche.

29. Dispositif selon la revendication 17, dans lequel le dispositif de mesure pour mesurer les variations d'épaisseur de la couche à la surface du substrat comprend une jauge d'épaisseur de couche.

30. Dispositif selon la revendication 17, dans lequel le dispositif de mesure pour mesurer les variations d'épaisseur de la couche à la surface du substrat comprend un dispositif de mesure de la température permettant de mesurer la température de la surface du substrat.
